# EUROPEAN PATENT APPLICATION

(11) **EP 2 568 785 A2**
(43) Date of publication of application: **13.03.2013**
(21) Application number: 12181796.9
(22) Date of filing: 24.08.2012
(51) Int. Cl.: H05K 5/06

(54) **Electronic apparatus**

(30) Priority: 08.09.2011 JP 2011195889
(71) Applicant: Sony Corporation, Tokyo 108-0075 (JP)
(72) Inventor: Kirihara, Toru, Minato-ku, Tokyo 108-0075 (JP); Matsumoto,Yuki, Minato-ku, Tokyo 108-0075 (JP)
(74) Representative: DeVile, Jonathan Mark

(57) **Abstract**

An electronic apparatus includes a first sealing member, a second sealing member, and a main body. The first sealing member has conductivity. The second sealing member is formed of an elastic material. The main body includes a first conductive casing, a second conductive casing, and a joining portion. The joining portion is configured to join the first casing and the second casing to each other. The joining portion includes a first attachment portion, a second attachment portion, and an anticorrosive protective layer. To the first attachment portion, the first sealing member is attached. The second attachment portion is formed on an outside air side of the first attachment portion. To the second attachment portion, the second sealing member is attached. The anticorrosive protective layer is formed on the outside air side of a contact portion of the second attachment portion and the second sealing member.

## Description

### Field of the Invention

The present disclosure relates to electronic apparatus such as image pickup apparatus which may be used for example outside.

### Background of the Invention

An electronic apparatus such as a video camera, for example, is often used outside. Therefore, a main body of the electronic apparatus needs to have a waterproof structure to prevent a raindrop from entering the main body in which an electronic component or the like is provided. For example, Japanese Patent Application Laid-open No. 2011-071362 (hereinafter referred to as Patent Document 1) discloses a metal casing of an outside apparatus such as a CATV repeater to which a gasket obtained by integrating a plurality of gaskets can be attached in order to hermetically seal space between a casing body and a casing cover. Moreover, Japanese Patent Application Laid-open No. 2001-124206 (hereinafter referred to as Patent Document 2) discloses a metal casing for a communication apparatus installed outside, in which a waterproof packing such as an O-ring is fitted on both abutment surfaces of a casing main body and a lid.

On the other hand, these electronic apparatuses themselves need to have an electromagnetic shielding function to suppress emission of an electromagnetic wave generated from their own electronic component or the like housed in the main body to outside, or to suppress entering of an electromagnetic wave into the main body from outside. Specifically, a plurality of casings constituting the main body need to be constituted of metal or the like having conductivity, and a joining portion of the casings needs to ensure not only a waterproof effect but also conductivity. Thus, when the electromagnetic wave from inside/outside the main body passes through the main body and the joining portion, the electromagnetic wave is attenuated by reflection on a surface thereof and absorption inside thereof, thereby enabling the main body to exert the electromagnetic shielding function as a whole.

For example, in Patent Document 1, conductivity of the entire metal casings is ensured by a configuration in which the metal casings to be joined and the shielding gasket are brought into contact with each other. In Patent Document 2, the above-mentioned waterproof packing has conductivity. This causes a contact portion between the casing main body formed of metal and the lid to maintain conductivity.

Incidentally, in the electronic apparatus including the main body formed of the metal casing, there is a possibility that a surface of the casing is corroded by a raindrop or the like. Regarding this point, although not described in Patent Document 1, Patent Document 2 describes that an anti-rust coating is applied to the casing main body and the lid. However, also in Patent Document 2, in order to ensure conduction, the anti-rust coating is not applied on the abutment surface between the casing main body and the lid, to which the waterproof packing is provided. Therefore, on an outside air side of a portion hermetically sealed by the above-mentioned waterproof packing on the above-mentioned abutment surface, the metal or the like constituting the casing is corroded by the entering of moisture, thereby degrading the aesthetic appearance thereof in some cases. Furthermore, there is a possibility that the corrosion progresses and thus a problem with the ensuring of the conduction on the contact surface is caused.

In view of the circumstances as described above, there is a need for an electronic apparatus capable of preventing corrosion on a joining portion between a plurality of casings.

Various aspects and features of the present invention are defined in the appended claims.

According to an embodiment of the present disclosure, there is provided an electronic apparatus including a first sealing member, a second sealing member, and a main body.

The first sealing member has conductivity.

The second sealing member is formed of an elastic material.

The main body includes a first conductive casing, a second conductive casing, and a joining portion configured to join the first casing and the second casing to each other. The joining portion includes a first attachment portion to which the first sealing member is attached, a second attachment portion, which is formed on an outside air side of the first attachment portion and to which the second sealing member is attached, and an anticorrosive protective layer that is formed on the outside air side of a contact portion between the second attachment portion and the second sealing member.

The first sealing member and the first attachment portion can ensure conductivity between the first casing and the second casing, thereby providing an electromagnetic shielding function to the main body. Moreover, the second sealing member disposed on the outside air side of the first sealing member and the second attachment portion can suppress entering of moisture into the contact portion between the second sealing member and the second attachment portion. Furthermore, it is possible to suppress the progress of corrosion on the joining portion by the anticorrosive protective layer. Accordingly, the main body can maintain the electromagnetic shielding function as a whole and further maintain the aesthetic appearance thereof.

The joining portion may include a first flange portion formed to the first casing and a second flange portion formed to the second casing.

The second attachment portion may include a groove portion that is formed in the first flange portion to house the second sealing member, and a plane portion that is formed to the second flange portion to face the groove portion.

Accordingly, the second sealing member formed of the elastic material can be brought into close contact with the groove portion and the plane portion, thereby enhancing sealing properties between the second attachment portion and the second sealing member.

The groove portion may include a first region to which the protective layer is formed and a second region to which the protective layer is not formed.

The protective layer is formed in the first region of the groove portion and thus, also in the groove portion, the protective layer can be formed on the outside air side of the contact portion between the second sealing member and the second attachment portion. Accordingly, it is possible to suppress the progress of corrosion on the outside air side of the contact portion and to maintain the aesthetic appearance of the joining portion. Further, since it becomes unnecessary to form the protective layer in the entire groove portion, the workability can be improved.

The first flange portion may be projected to an outside of the second flange portion, and the plane portion may cover a part of the groove portion.

Accordingly, a step of such a height that a part of the second sealing member is exposed can be provided between the first flange portion and the second flange portion. The step prevents moisture from being retained in a narrow area, and thus it is possible to further suppress entering of moisture into the joining portion.

Moreover, the protective layer may be a coating film, and, more specifically, the coating film may be a spray coating film.

Accordingly, the protective layer can be formed easily, and thus it is possible to form the protective layer to the groove portion appropriately, for example.

As described above, according to the embodiments of the present disclosure, it is possible to provide an electronic apparatus that is capable of preventing corrosion on a joining portion of a plurality of casings and maintaining the aesthetic appearance thereof.

These and other objects, features and advantages of the present disclosure will become more apparent in light of the following detailed description of best mode embodiments thereof, as illustrated in the accompanying drawings.

### Brief Description of Drawings

Embodiments of the present invention will now be described with reference to the accompanying drawings in which like parts have corresponding reference numerals and in which:
Fig. 1 is an exploded top view of a main body of an electronic apparatus according to a first embodiment of the present disclosure;
Fig. 2 is a side view of a first casing according to the first embodiment of the present disclosure as viewed from a direction [A] in Fig. 1;
Fig. 3 is a side view of a second casing according to the first embodiment of the present disclosure as viewed from a direction [B] in Fig. 1;
Fig. 4 is a schematic cross-sectional view showing a configuration of a joining portion according to the first embodiment of the present disclosure and is a view showing a state where a cross-sectional surface in a direction [C]-[C] in Fig. 2 and a cross-sectional surface in a direction [D]-[D] in Fig. 3 are joined;
Fig. 5 is another schematic cross-sectional view showing the configuration of the joining portion according to the first embodiment of the present disclosure and is an enlarged view of a main portion in Fig. 4;
Fig. 6 is a schematic cross-sectional view showing configurations of a first flange portion and a first attachment portion according to the first embodiment of the present disclosure and is an enlarged view of the main portion in Fig. 4;
Fig. 7 is a schematic cross-sectional view showing a method of forming an anticorrosive coating film according to the first embodiment of the present disclosure;
Fig. 8 is a schematic cross-sectional view showing a method of forming an anticorrosive coating film according to a modified example of the first embodiment of the present disclosure;
Fig. 9 is a schematic cross-sectional view showing a configuration of a joining portion according to a second embodiment of the present disclosure;
Fig. 10 is a schematic cross-sectional view showing a configuration of a joining portion according to a modified example of embodiments of the present disclosure; and
Fig. 11 is a schematic cross-sectional view showing a configuration of a joining portion according to another modified example of the embodiments of the present disclosure.

### Detailed Description of Embodiments

Hereinafter, embodiments according to the present disclosure will be described with reference to the drawings.

### <First Embodiment>

### (Configuration of Electronic Apparatus)

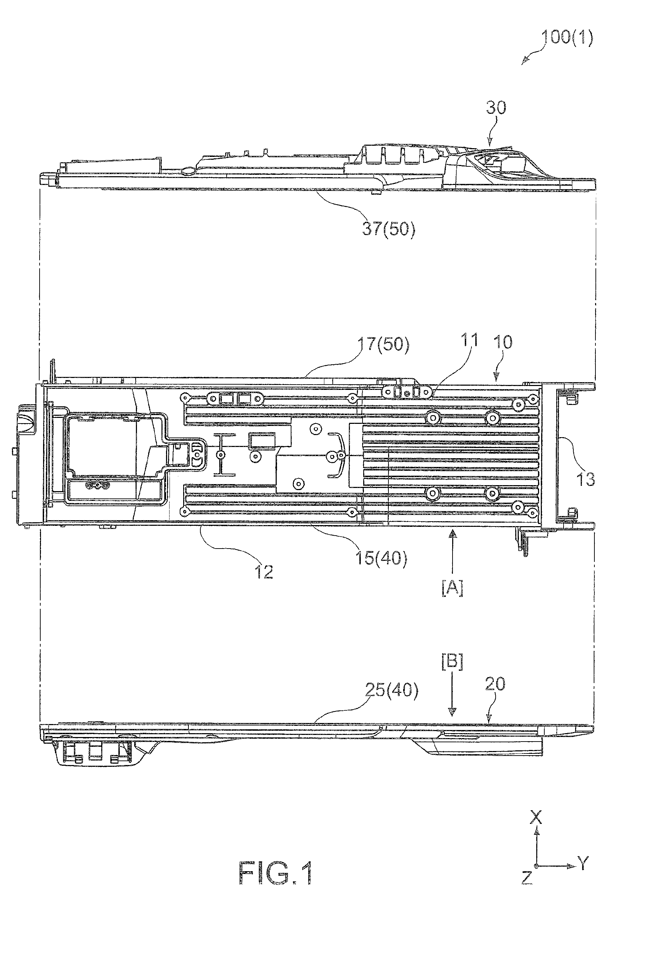

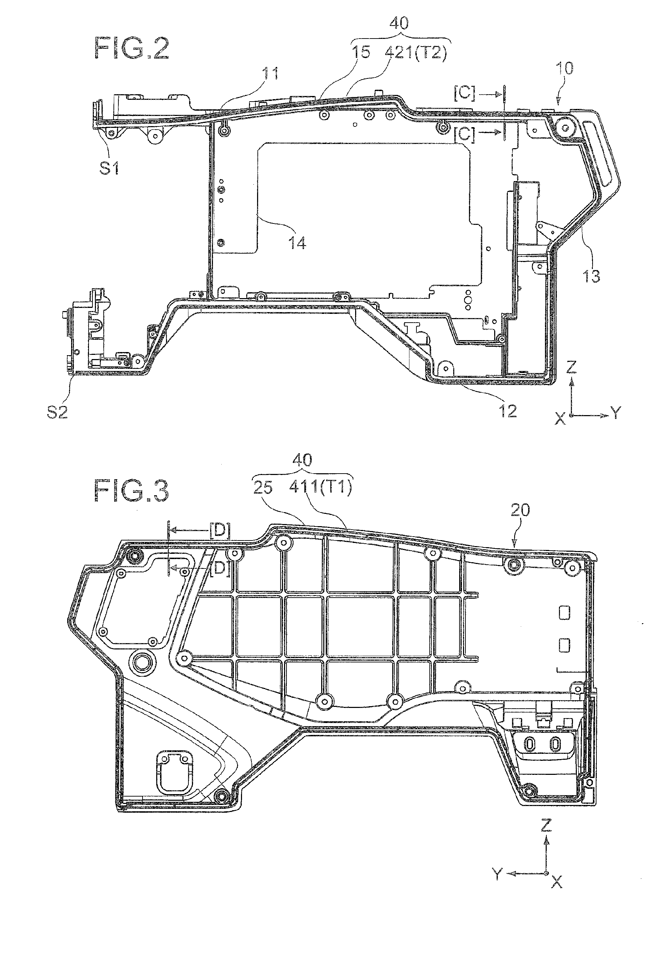

Figs. 1 to 3 show a configuration of a main body 1 of an electronic apparatus 100 according to this embodiment. The main body 1 includes a first casing 10, a second casing 20, and a third casing 30. Fig. 1 is an exploded top view of the main body 1, Fig. 2 is a side view of the first casing 10 as viewed from a direction [A] in Fig. 1, and Fig. 3 is a side view of the second casing 20 as viewed from a direction [B] in Fig. 1.

The electronic apparatus 100 according to this embodiment further includes a shield tube (first sealing member) T1 and an elastic tube (second sealing member) T2. The main body 1 includes a joining portion 40 formed between the first casing 10 and the second casing 20 and a joining portion 50 formed between the first casing 10 and the third casing 30, and the shield tube T1 and the elastic tube T2 are attached to the joining portion 40 and the joining portion 50, respectively. The electronic apparatus 100 is, for example, a portable camera for a broadcasting service, and, although not shown, various electronic components such as an image pickup device, a signal processing circuit, and a recording/reproducing apparatus, and various mechanism components such as an optical lens and a lens driving mechanism are housed within the inside space of the main body 1.

It should be noted that, in the figures, an X-axis direction and a Y-axis direction indicate horizontal directions that are orthogonal to each other, and a Z-axis direction indicates a direction that is perpendicular to both the X-axis direction and the Y-axis direction. Moreover, in this embodiment, the X-axis direction indicates a width direction of the main body 1, the Y-axis direction indicates a front-back direction of the main body 1, and the Z-axis direction indicates a height direction (vertical direction) of the main body 1. Further, the second casing 20 constitutes a left side surface of the main body 1 and the third casing 30 constitutes a right side surface of the main body 1. Moreover, in the following description, the term "inside" means a side or portion which is surrounded by the first casing 10, the second casing 20, and the third casing 30, and the term "outside air side" or "outside" means a portion which is an opposite side of the "inside" with respect to the first casing 10, the second casing 20, and the third casing 30.

### [Configuration of Main Body]

In this embodiment, the main body 1 includes the first casing 10, the second casing 20, and the third casing 30. Additionally, the main body 1 may further include a plurality of casings, components, and the like (not shown). The first casing 10 and the second casing 20 are integrated by being fixed at several positions thereof by screws or the like, thereby constituting the joining portion 40. The shield tube T1 and the elastic tube T2 are attached to the joining portion 40.

Similarly, the first casing 10 and the third casing 30 are integrated by being fixed at several positions thereof by screws or the like, thereby constituting the joining portion 50. The joining portion 50 has the same configuration as that of the joining portion 40. The shield tube T1 and the elastic tube T2 are attached to the joining portion 50.

It should be noted that an anticorrosive coating film P1 (not shown in Figs. 1 to 3), which will be described later, is formed on a surface of an outside air side of the first casing 10, the second casing 20, and the third casing 30.

### (First Casing)

The first casing 10 includes an upper plate 11 and a lower plate 12 that face each other in the Z-axis direction and are connected to each other through a back surface frame 13 and an internal frame 14. The back surface frame 13 constitutes a back surface of the main body 1. Moreover, the internal frame 14 is a supporting body including a YZ plane that is orthogonal to the X-axis direction. The internal frame 14 is formed inside the first casing 10 and supports the upper plate 11 and the lower plate 12. That is, the first casing 10 has a configuration in which a front surface and both side surfaces thereof are opened. An image pickup optical system such as a lens barrel is provided in an opening area formed to the front surface of the main body 1.

The first casing 10 is formed of a metal material and is, in this embodiment, formed by die casting of magnesium (Mg). Therefore, the first casing 10 is configured to have conductivity, a high strength, and light weight.

The first casing 10 includes a first flange portion 15. The first flange portion 15 is continuously formed along a rim of each of the upper plate 11, the back surface flame 13, and the lower plate 12. The first flange portion 15 constitutes the joining portion 40 that joins the first casing 10 and the second casing 20 to each other. A groove portion 421, which includes an opening on a side of the second casing 20, is formed in the first flange portion 15. The elastic tube T2, which is indicated by a heavy line in Fig. 2, is fitted into the groove portion 421. In this embodiment, the groove portion 421 is formed of a single groove that is continuously formed between a point S1 on the upper plate 11 and a point S2 on the lower plate 12 shown in Fig. 2.

The elastic tube T2 is formed of a linear sealing member having ends to be attached to the groove portion 421 that is formed between the point S1 and the point S2. The constituent material of the elastic tube T2 is not particularly limited and is, in this embodiment, formed of silicone rubber.

The configuration of the groove portion 421 is not limited to the configuration in which the groove portion 421 is continuously formed between the point S1 and the point S2. For example, the groove portion 421 may be discontinuously formed between the point S1 and the point S2. Furthermore, since the elastic tube T2 is mainly configured as a sealing member for preventing a raindrop or the like from entering the main body 1 from outside, the groove portion 421 housing the elastic tube T2 may be formed only at the rims of the upper plate 11 and the back surface frame 13.

On the other hand, on a side surface opposite to the upper plate 11, the lower plate 12, and the back surface frame 13 of the first casing 10, a third flange portion 17 having the same configuration as that of the first flange portion 15 is formed, and the first casing 10 and the third casing 30 are joined to each other through the joining portion 50 including the third flange portion 17.

### (Second Casing)

The second casing 20 has a plate-like structure constituting the left side surface of the main body 1. The second casing 20 is formed by die casting of Mg as in the first casing 10.

The second casing 20 includes a second flange portion 25. The second flange portion 25 is continuously and annularly formed along a rim of an inner surface side of the second casing 20. A groove portion 411, which includes an opening on a side of the first casing 10, is formed in the second flange portion 25. The shield tube T1 is fitted into the groove portion 411. The first casing 10 and the second casing 20 are fixed by the screws or the like, so that the second flange portion 25 is joined to the first flange portion 15 in the X-axis direction. Both the first flange portion 15 and the second flange portion 25 constitute a part of the joining portion 40.

Although the groove portion 411 is continuously and annularly formed along an end surface of the second flange portion 25 in this embodiment, the groove portion 411 may be formed discontinuously. The shield tube T1 is attached along the groove portion 411 in a continuous and annular form. However, the attachment of the shield tube T1 is not limited thereto, and the shield tube T1 may be attached at predetermined positions of the groove portion 411 in a discontinuous form.

### (Third Casing)

The third casing 30 has a plate-like structure constituting a right side surface of the main body 1. The third casing 30 is formed by die casting of Mg as in the first casing 10.

The third casing 30 includes a fourth flange portion 37. The fourth flange portion 37 is continuously and annularly formed along a rim of an inner surface side of the third casing 30. A groove portion (not shown), which includes an opening on the side of the first casing 10, is formed in the fourth flange portion 37. The groove portion has the same configuration as that of the groove portion 411 and the shield tube T1 is fitted into the groove portion. The first casing 10 and the third casing 30 are fixed by the screws or the like, so that the fourth flange portion 37 is joined to the third flange portion 17 in the X-axis direction. Both the third flange portion 17 and the fourth flange portion 37 constitute a part of the joining portion 50.

The first casing 10, the second casing 20, and the third casing 30 are configured as described above. Next, the detailed configuration of the joining portion 40 in which the first casing 10 and the second casing 20 are joined will be described. It should be noted that since the joining portion 50 has the same configuration as that of the joining portion 40, the description of the detailed configuration of the joining portion 50 will be omitted in the following.

### [Configuration of Joining Portion]

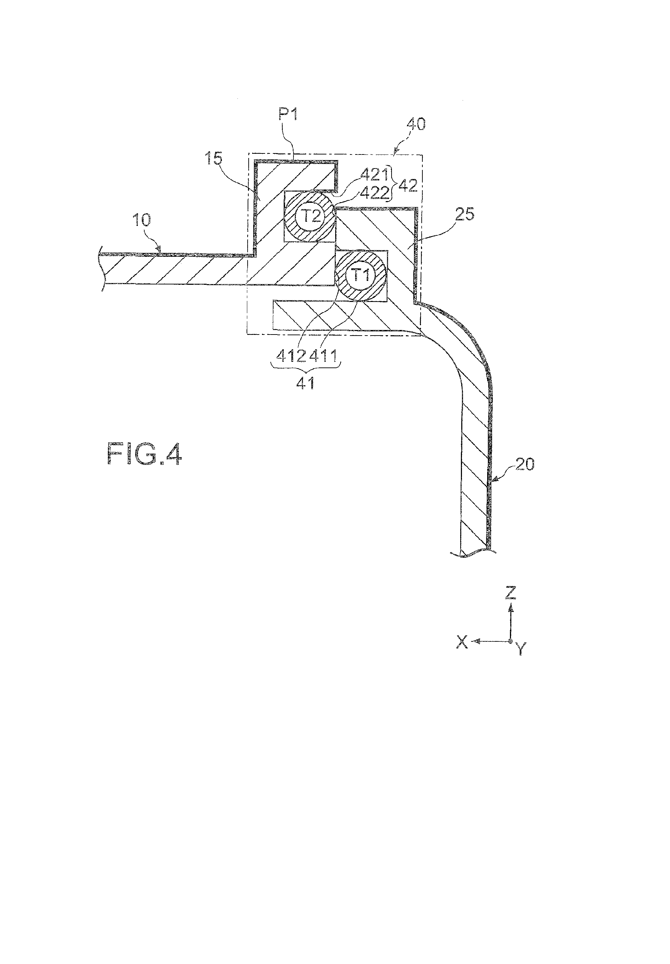

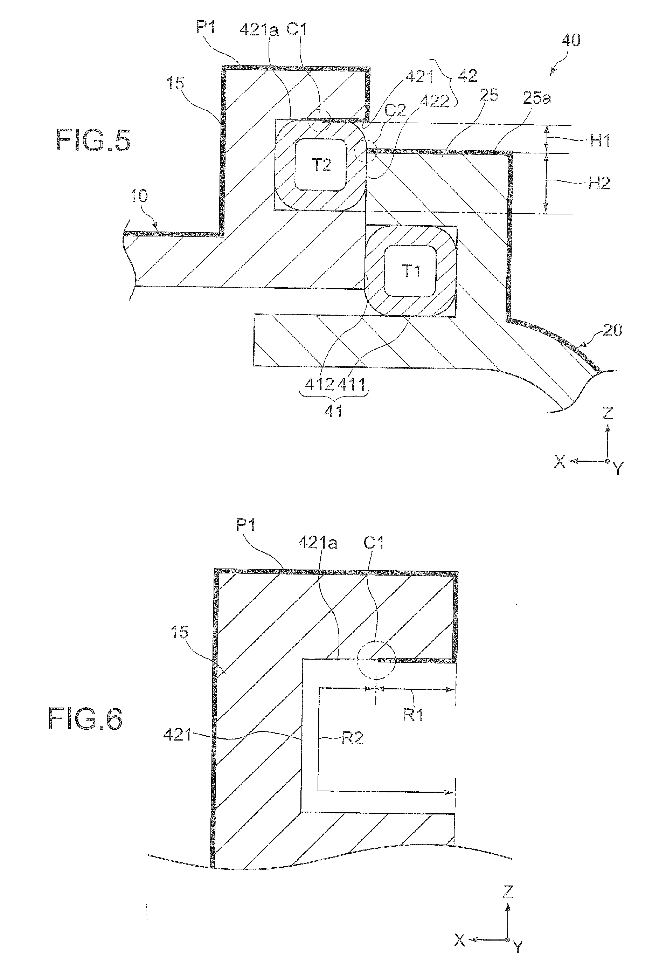

Fig. 4 is a schematic cross-sectional view showing a configuration of the joining portion 40 according to this embodiment and is a view showing a state where a cross-sectional surface in a direction [C]-[C] in Fig. 2 and a cross-sectional surface in a direction [D]-[D] in Fig. 3 are joined. Fig. 5 is another schematic cross-sectional view showing the configuration of the joining portion 40 and is an enlarged view of a main portion in Fig. 4. Fig. 6 is a schematic cross-sectional view showing configurations of the first flange portion 15 and a first attachment portion 41 and is an enlarged view of the main portion in Fig. 4.

The joining portion 40 is constituted of the first flange portion 15 and the second flange portion 25 and includes the first attachment portion 41, a second attachment portion 42, and the anticorrosive coating film (protective layer) P1. The first flange portion 15 and the second flange portion 25 face each other in the X-axis direction, and the first flange portion 15 is projected to the outside of the second flange portion by a predetermined height. The shield tube T1 is attached to the first attachment portion 41. The elastic tube T2 is attached to the second attachment portion 42. The anticorrosive coating film P1 is formed to the outside air side of contact surfaces (contact portions) C1 and C2 between the second attachment portion 42 and the elastic tube T2. It should be noted that, in Figs. 4 to 11, parts on which the anticorrosive coating film P1 is formed are indicated by heavy lines.

### (First Attachment Portion)

The first attachment portion 41 includes the groove portion 411 and a plane portion 412. The groove portion 411 is a groove that is formed in the second flange portion 25 of the second casing 20 and includes an opening on a side of the first flange portion 15. The shield tube T1 is fitted into the groove portion 411. On the other hand, the plane portion 412 faces the groove portion 411 so as to cover a part of the groove portion 411 and is formed to the first flange portion 15 of the first casing 10. That is, in this embodiment, the first attachment portion 41 forms a space for housing the shield tube T1, which is formed of the groove portion 411 and the plane portion 412.

The shield tube T1 is used to provide an electromagnetic shield function to the entire area of the main body 1 by ensuring conduction between the first casing 10 having conductivity and the second casing 20 having conductivity. A material for forming the shield tube T1 is not particularly limited as long as the surface of the shield tube T1 is formed of a material having conductivity. For example, a shield tube including a core of a hollow silicone tube formed of an elastic material, which is coated with a metal material such as nickel (Ni), can be employed. The diameter of the shield tube T1 is not particularly limited and is selected as appropriate depending on the width of an opening of the groove portion 411. The diameter of the shield tube T1 may be about 2 mm, for example. Such a shield tube T1 itself has elastic properties, and thus is brought into close contact with the groove portion 411 and the plane portion 412 with a certain elastic force.

The size of the groove portion 411 to be formed is not particularly limited, and the distance from the opening to the bottom and the width between the wall surfaces of the groove portion 411 may be smaller than the diameter of the shield tube T1. For example, in this embodiment, the distance from the opening to the bottom and the width between the wall surfaces of the groove portion 411 are smaller than 2 mm. Accordingly, the shield tube T1 having elastic properties is crushed to have rounded corners in the first attachment portion 41, as shown in Fig. 5, and is housed so as to be brought into close contact with a part of the groove portion 411 and the plane portion 412. It should be noted that since the anticorrosive coating film P1, which will be described later, is not applied on the groove portion 411 and the plane portion 412, conductivity between these portions and the shield tube T1 is ensured.

As described above, the shield tube T1 comes into contact with the first casing 10 having conductivity and the second casing 20 having conductivity, thereby enabling the shield tube T1 to ensure conductivity with these casings. The shield tube T1 is attached to the first attachment portion 41 having the above-mentioned configuration, so that the entire main body 1 can have conductivity. Therefore, when an electromagnetic wave from inside/outside the main body 1 passes through the main body 1, the joining portion 40, the joining portion 50, or the like, the electromagnetic wave is attenuated by reflection on the surface thereof and absorption inside thereof, thereby enabling the main body 1 to exert an electromagnetic shielding function as a whole.

### (Second Attachment Portion)

The second attachment portion 42 is formed on the outer periphery side of the first attachment portion 41. The second attachment portion 42 includes the groove portion 421 and a plane portion 422. The groove portion 421 is a groove for fitting the elastic tube T2 thereinto and includes an opening on a side of the second flange portion 25. Farther, the groove portion 421 is formed in the first flange portion 15 of the first casing 10. On the other hand, the plane portion 422 is formed to the second flange portion 25 of the second casing 20. The plane portion 422 is formed to the second flange portion 25 so as to face the groove portion 421 and cover a part of the groove portion 421. That is, the second attachment portion 42 forms a space for housing the elastic tube T2, which is formed of the groove portion 421 and the plane portion 422. It should be noted that, as shown in Fig. 5, the width of the plane portion 422 covering the groove portion 421 is denoted by H2 and the width of an opening of the groove portion 421 being exposed is denoted by H1.

The elastic tube T2 is used to suppress entering of moisture such as a raindrop into the main body 1 from the joining portion 40. A material for forming the elastic tube T2 is not particularly limited as long as the elastic tube T2 is formed of an elastic material. For example, the same material as the silicone tube used for the core of the shield tube T1 can be employed. The diameter of the elastic tube T2 is not particularly limited and is selected as appropriate depending on the width of the opening of the groove portion 421. The diameter of the elastic tube T2 may be about 1.6 mm, for example.

The size of the groove portion 421 to be formed is not particularly limited, and the distance from the opening to the bottom and the width between the wall surfaces of the groove portion 421 (i.e., H1 + H2 in Fig. 5) may be smaller than the diameter of the elastic tube T2. For example, in this embodiment, the distance from the opening to the bottom and the width between the wall surfaces of the groove portion 421 are smaller than 1.6 mm. Accordingly, the elastic tube T2 is crushed to have rounded corners in the second attachment portion 42, as shown in Fig. 5. That is, the elastic tube T2 is formed so as to be brought into close contact with the contact surfaces (contact portions) C1 and C2 of the groove portion 421 and the plane portion 422.

The contact surface C1 is a surface on which the groove portion 421 and the elastic tube T2 are brought into contact with each other at the most outside air side, as shown in Fig. 5, out of surfaces on which the groove portion 421 and the elastic tube T2 are brought into contact with each other. On the other hand, the contact surface C2 is a surface on which the plane portion 422 and the elastic tube T2 are brought into contact with each other, and is formed near an end surface 25a of the second flange portion 25. These contact surfaces C1 and C2 are formed, as a whole, along an extending direction of the groove portion 421 and the elastic tube T2. The elastic tube T2 and the first casing 10 and the second casing 20 are brought into close contact with each other on the contact surfaces C1 and C2, and thus it is possible to suppress entering of moisture from the outside air side.

As shown in Fig. 6, the groove portion 421 includes a first area R1 on which the anticorrosive coating film P1 is applied and a second area R2 on which the anticorrosive coating film P1 is not applied. The first area R1 is an area to be formed to at least the outside air side of the contact surface C1 of the groove portion 421, and is formed to an outer wall surface 421a on the outside air side of the groove portion 421. On the other hand, the second area R2 is an area to be formed inside the contact surface C1 of the groove portion 421. That is, in this embodiment, the anticorrosive coating film P1 is applied to the first area R1, which is brought into contact with outside air and a raindrop or the like may be attached to. Accordingly, the corrosion due to rust or the like in the joining portion 40 can also be suppressed and the aesthetic appearance can be maintained. Furthermore, since it becomes unnecessary to apply the anticorrosive coating film P1 in the entire groove portion 421, the workability can be improved.

Now, a method of forming the anticorrosive coating film P1 to the first area R1 will be described.

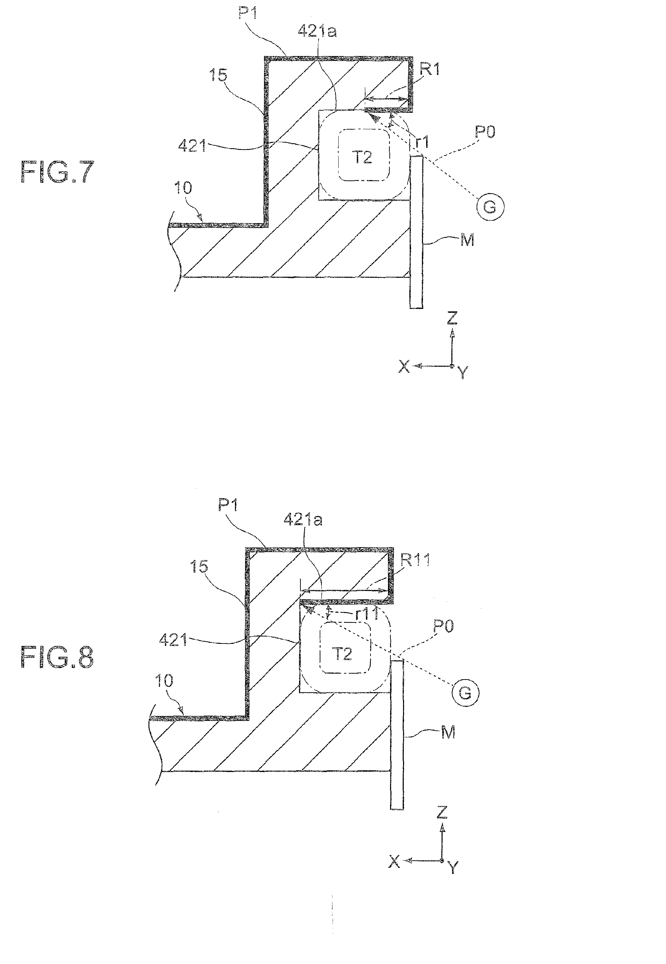

Fig. 7 is a schematic cross-sectional view showing a method of forming the anticorrosive coating film P1 in the groove portion 421. In this embodiment, the anticorrosive coating film P1 is a spray coating film formed by spray coating. The spray coating is a coating method of forming the anticorrosive film P1 by spraying, to a desired area, paint P0 in a mist form by a spray gun G or the like. It should be noted that the paint P0 used in this embodiment is not limited as long as the paint P0 has an anticorrosive (anti-rust) function.

The dashed line in Fig. 7 schematically shows the paint P0 to be sprayed to the outer wall surface 421a. To apply the paint P0 to the first area R1 of the groove portion 421, for example, the paint P0 is sprayed from an oblique direction by the spray gun G, as shown in Fig. 7. The paint P0 is sprayed at an angle r1 with respect to the outer wall surface 421a of the groove portion 421 from the spray gun G.

A part of the opening of the groove portion 421 is shielded by a plate-like or tape-like mask M. The spray gun G sprays the paint P0 to the outer wall surface 421a while changing the relative position between the spray gun G and the mask M. Accordingly, the anticorrosive coating film P1 can be appropriately formed to the first area R1.

Here, Fig. 8 shows an example in which a first area R11 is formed on an entire surface of the outer wall surface 421a, as a modified example of this embodiment. In the modified example, the paint P0 can be sprayed, from the spray gun G, at an angle r11 with respect to the outer wall surface 421a constituting the first area R11. Here, the angle r11 is smaller than the angle r1. According to the modified example, the first area R11 is formed on the entire surface of the outer wall surface 421a, so that an anticorrosive effect on the joining portion 40 can be more enhanced.

On the other hand, in this embodiment, the elastic tube T2 and the groove portion 421 are brought into close contact with each other on the contact surface C1, so that a structure which prevents a raindrop or the like attached to the main body 1 from entering the contact surface C1 can be obtained. Therefore, if the anticorrosive coating film P1 is applied to the first area R1 on the outside air side of the contact surface C1, the sufficient anticorrosive function of the joining portion 40 can be obtained. The anticorrosive coating film P1 is formed only to the first area R1, so that the spray coating can be performed at smaller angle than the above-mentioned modified example. Thus, the workability of the spray coating can be more improved.

The anticorrosive coating film P1 is formed not only to the first area R1 but also to the outside air side of the contact surfaces C1 and C2 of the joining portion 40. It should be noted that the anticorrosive coating film P1 can be formed to entire surfaces on the outside air side of the first casing 10 and the second casing 20.

The elastic tube T2 and the plane portion 422 are brought into close contact with each other on the contact surface C2. Accordingly, it is possible to suppress entering of moisture or the like into the first attachment portion 41. Furthermore, it is also possible to suppress, by the anticorrosive protective film P1, the progress of the corrosion on the inside of the contact surface C2. Thus, the conductivity between the shield tube T1 and the first casing 10 and the second casing 20 can be maintained and the electromagnetic shield function of the entire main body 1 can also be maintained.

Moreover, as shown in Fig. 5, the groove portion 421 is covered with the plane portion 422 by the width H2 and is exposed by the width H1 in this embodiment. Therefore, the end surface 25a of the second flange portion 25 is disposed, by the width H1, on the inside of the outer wall surface 421a of the groove portion 421 of the first flange portion 15 in this embodiment. The ratio between H1 and H2 is not particularly limited, and can be set to about 1:2, for example.

With this structure, a step, on which the elastic tube T2 can be exposed by the width H1, can be provided between the first flange portion 15 and the second flange portion 25. With this step, the joining portion 40 according to this embodiment can be configured to have an open area retaining few raindrops or the like at the outside air side of the contact surfaces C1 and C2. Therefore, it is possible to more suppress entering of moisture into the joining portion 40.

### <Second Embodiment>

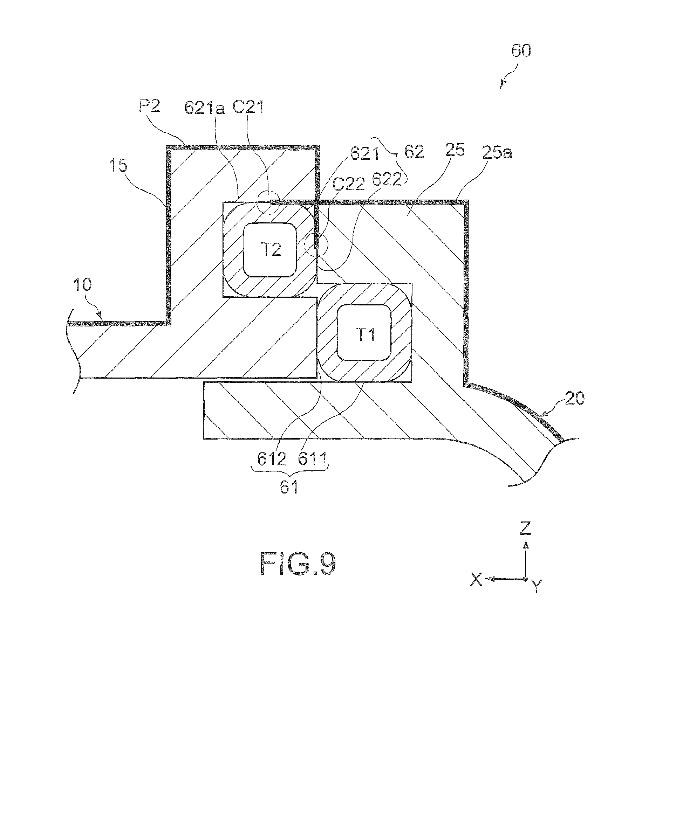

Fig. 9 is a schematic cross-sectional view showing a configuration of a joining portion 60 according to a second embodiment of the present disclosure. In this embodiment, although the joining portion 60 includes the first casing 10 and the second casing 20 having the same configurations as those of the first embodiment, the joining portion 60 constituted of the first casing 10 and the second casing 20 has a different configuration from that of the first embodiment. It should be noted that the same components as those according to the first embodiment shown in the figure will be denoted by the same reference symbols and detailed descriptions thereof will be omitted.

The joining portion 60 includes a first attachment portion 61, a second attachment portion 62, and an anticorrosive coating film P2. The shield tube T1 is attached to the first attachment portion 61. The elastic tube T2 is attached to the second attachment portion 62. The first attachment portion 61 is constituted of a groove portion 611 and a plane portion 612, and the second attachment portion 62 is constituted of a groove portion 621 and a plane portion 622. The anticorrosive coating film P2 is formed on the outside air side of contact surfaces C21 and C22 between the second attachment portion 62 and the elastic tube T2.

A step of the joining portion 60 between the first flange portion 15 and the second flange portion 25 is smaller than that of the first embodiment. That is, the end surface 25a of the second flange portion 25 is disposed almost at the same height as an outer wall surface 621a of the groove portion 621. Accordingly, an area on the outside air side of the contact surface C22 of an opening of the groove portion 621 is mainly covered with the plane portion 622.

The plane portion 622 and the elastic tube T2 are brought into close contact with each other on the contact surface C22 as in the first embodiment. Accordingly, even if a raindrop or the like enters a slight gap between the groove portion 621 and the plane portion 622, it is possible to suppress entering of the raindrop or the like into the first attachment portion 61.

On the other hand, the anticorrosive coating film P2 is formed also on an area on the outside air side of the contact surface C22 of the plane portion 622 in the second casing 20. Accordingly, the corrosion on the outside air side of the contact surface C22 can be suppressed and the aesthetic appearance of the joining portion 60 can be maintained. Furthermore, the joining portion 60 can have a compact structure and a degree of freedom of design can be increased.

Although the embodiments of the present disclosure have been described, the embodiments of the present disclosure are not limited thereto, and various modifications can be made based on the technical ideas of the present disclosure. In the following, modified examples according to the embodiments of the present disclosure will be described.

### <Modified Example 1>

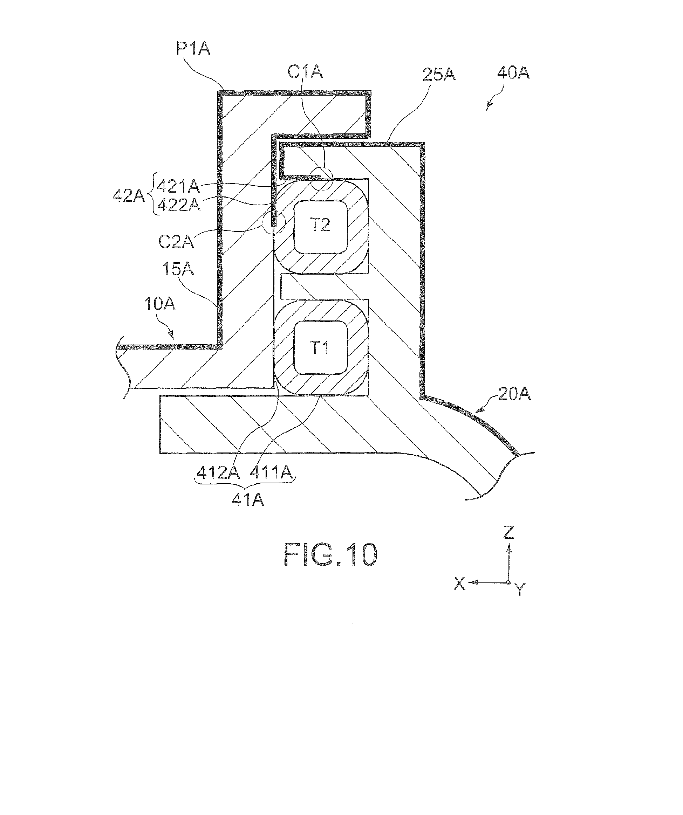

Fig. 10 is a schematic cross-sectional view showing a configuration of a joining portion 40A according to a modified example 1 of the embodiments of the present disclosure. In the modified example 1, a first flange portion 15A of a first casing 10A and a second flange portion 25A of a second casing 20A each have a different configuration from that of the first embodiment.

In the modified example 1, groove portions 411A and 421A are formed on the side of the second flange portion 25A. Also with such a configuration, it is possible to suppress entering of moisture or the like into the joining portion 40A by contact surfaces C1A and C2A. Further, by forming an anticorrosive coating film P1A on the outside air side of the contact surfaces C1A and C2A, the corrosion on the outside air side of the contact surfaces C1A and C2A can be suppressed and the aesthetic appearance of the joining portion 40A can be maintained.

### <Modified Example 2>

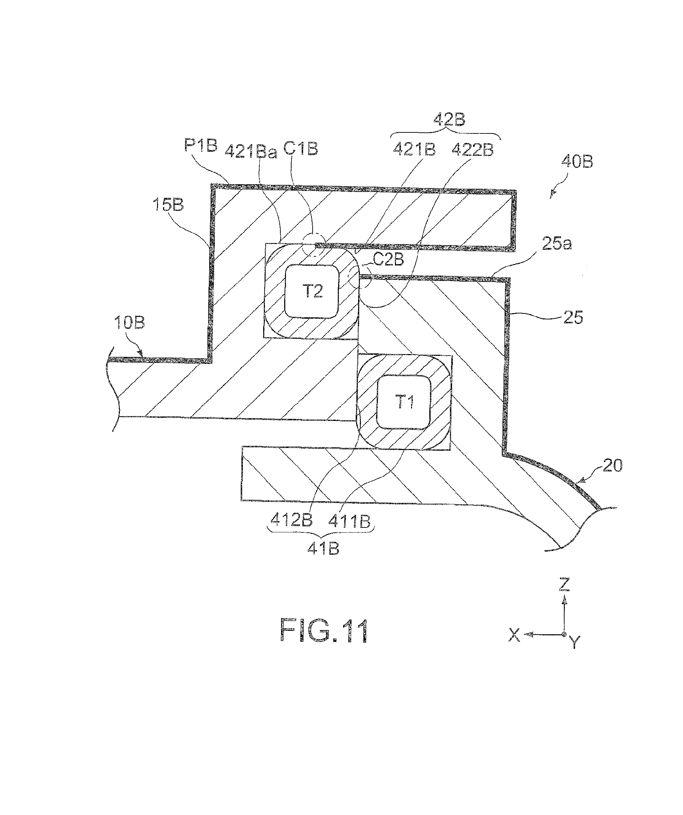

Fig. 11 is a schematic cross-sectional view showing a configuration of a joining portion 40B according to a modified example 2 of the embodiments of the present disclosure. In the modified example 2, a first flange portion 15B has a different configuration from that of the first embodiment. That is, the joining portion 40B has a configuration in which a wall surface 421Ba on the outside air side of a groove portion 421B is formed so as to cover the end surface 25a of the second flange portion 25 so that the second flange portion 25 is difficult to be seen from outside. With such a joining portion 40B, in addition to the same effects as those of the first embodiment, the aesthetic appearance of the joining portion 40B can be improved.

Although the protective layer is described as the anticorrosive film in the above-mentioned embodiments, the protective layer is not limited thereto. For example, the protective layer may be formed of an anti-rust film, or by applying anti-rust treatment or the like with the use of a surface processing agent or the like. Alternatively, the protective layer may be a passivation film formed on the surface of a casing.

Moreover, the method of forming the anticorrosive coating film is also not limited to the spray coating, and a brush coating or the like may be employed.

It should be noted that the present disclosure may also employ the following configurations.
(1) An electronic apparatus, including:
   a first sealing member having conductivity;
   a second sealing member formed of an elastic material; and
   a main body including
      a first conductive casing,
      a second conductive casing, and
      a joining portion configured to join the first casing and the second casing to each other, the joining portion including
      a first attachment portion to which the first sealing member is attached,
      a second attachment portion, which is formed on an outside air side of the first attachment portion and to which the second sealing member is attached, and
      an anticorrosive protective layer that is formed on the outside air side of a contact portion between the second attachment portion and the second sealing member.
(2) The electronic apparatus according to (1), in which
   the joining portion includes a first flange portion formed to the first casing and a second flange portion formed to the second casing, and
   the second attachment portion includes a groove portion that is formed in the first flange portion to house the second sealing member, and a plane portion that is formed to the second flange portion to face the groove portion.
(3) The electronic apparatus according to (2), in which
   the groove portion includes a first region to which the protective layer is formed and a second region to which the protective layer is not formed.
(4) The electronic apparatus according to (2) or (3), in which
   the first flange portion is projected to an outside of the second flange portion, and
   the plane portion covers a part of the groove portion.
(5) The electronic apparatus according to any one of (1) to (4), in which
   the protective layer is a coating film.
(6) The electronic apparatus according to (5), in which
   the coating film is a spray coating film.

The present disclosure contains subject matter related to that disclosed in Japanese Priority Patent Application JP 2011-195889 filed in the Japan Patent Office on September 8, 2011, the entire content of which is hereby incorporated by reference.

It should be understood by those skilled in the art that various modifications, combinations, sub-combinations and alterations may occur depending on design requirements and other factors insofar as they are within the scope of the appended claims or the equivalents thereof.

## Claims

1. An electronic apparatus, comprising:
a first sealing member having conductivity;
a second sealing member formed of an elastic material; and
a main body including
a first conductive casing,
a second conductive casing, and
a joining portion configured to join the first casing and the second casing to each other, the joining portion including
a first attachment portion to which the first sealing member is attached,
a second attachment portion, which is formed on an outside air side of the first attachment portion and to which the second sealing member is attached, and
an anticorrosive protective layer that is formed on the outside air side of a contact portion between the second attachment portion and the second sealing member.

2. The electronic apparatus according to claim 1, wherein
the joining portion includes a first flange portion formed to the first casing and a second flange portion formed to the second casing, and
the second attachment portion includes a groove portion that is formed in the first flange portion to house the second sealing member, and a plane portion that is formed to the second flange portion to face the groove portion.

3. The electronic apparatus according to claim 2, wherein
the groove portion includes a first region to which the protective layer is formed and a second region to which the protective layer is not formed.

4. The electronic apparatus according to claim 2, wherein
the first flange portion is projected to an outside of the second flange portion, and
the plane portion covers a part of the groove portion.

5. The electronic apparatus according to claim 1, wherein
the protective layer is a coating film.

6. The electronic apparatus according to claim 5, wherein
the coating film is a spray coating film.
